# FASCICULE DE BREVET EUROPEEN

(11) **EP 3 122 035 B1**
(45) Date de publication et mention de la délivrance du brevet: **16.10.2019**
(21) Numéro de dépôt: 16180798.7
(22) Date de dépôt: 22.07.2016
(51) Int. Cl.: H04N 5/355, H01L 27/146, H04N 5/363

(54) **CAPTEUR D'IMAGE A PIXELS ACTIFS AVEC FONCTIONNEMENT EN MODE D'OBTURATEUR GLOBAL, SOUSTRACTION DU BRUIT DE REINITIALISATION ET LECTURE NON DESTRUCTIVE**
BILDSENSOR MIT AKTIVEN PIXELN MIT GLOBAL-SHUTTER-BETRIEBSMODUS, SUBSTRAKTION DES RESET-GERÄUSCHES UND NICHT-DESTRUKTIVER BILDWIEDERGABE
ACTIVE PIXEL IMAGE SENSOR WITH OPERATION IN GLOBAL SHUTTER MODE, RESET NOISE SUBTRACTION AND NON-DESTRUCTIVE READING

(30) Priorité: 24.07.2015 FR 1557073
(43) Date de publication de la demande: 25.01.2017
(73) Titulaire: Pyxalis, 38430 Moirans (FR)
(72) Inventeur: CHENEBAUX, Grégoire, 38000 GRENOBLE (FR)
(74) Mandataire: Priori, Enrico

(56) Documents cités:
- WO-A1-2010/066850
- FR-A1- 2 939 950
- US-A- 5 818 898
- US-A1- 2003 076 431
- US-A1- 2007 045 681

## Description

L'invention porte sur un capteur d'image du type à pixels actifs et sur un procédé d'acquisition d'images utilisant un tel capteur. L'invention vise notamment à permettre l'acquisition d'images en mode d'obturateur global avec soustraction du bruit de réinitialisation en association avec de la lecture non destructive des pixels.

Les capteurs d'image à pixels actifs, généralement réalisés en technologie CMOS (métal, oxyde, semi-conducteur complémentaire) sont couramment utilisés dans les systèmes d'imagerie électroniques. Dans ces capteurs, chaque pixel comprend une photodiode, optionnellement un noeud de stockage des charges photogénérées par la photodiode (« diffusion flottante ») dans le cas d'utilisation d'une photodiode pincée (« pinned photodiode » en anglais), et une pluralité de transistors (typiquement entre 3 et 5 par pixel). Une introduction générale à ces capteurs est fournie, par exemple, par l'article de Abbas El Gamal et Helmu Rlyoukhy « CMOS Image Sensors », IEEE Circuits & Devices Magazine, mai-juin 2005, pages 6 à 20.

Il est connu que les capteurs d'image à pixels actifs peuvent fonctionner sans besoin d'utiliser un obturateur mécanique. La fonction de l'obturateur est alors obtenue de manière purement électronique, par un pilotage approprié des transistors de chaque pixel. L'obturateur électronique ainsi réalisé peut être de type « roulant » ou « global ».

Dans le cas d'un obturateur roulant (« rolling shutter » en anglais) les périodes d'intégration des différentes lignes de pixels sont déphasée les unes par rapport aux autres. Le document WO2010066850 divulgue un capteur d'image fonctionnant notamment avec un obturateur roulant. Afin d'étendre la plage dynamique du capteur, la lecture des charges d'un pixel y est conditionnée par la proximité ou non de la saturation du noeud de stockage. Le document FR2939950 divulgue un autre capteur avec un obturateur roulant, dans lequel une extension de la plage dynamique est obtenue en évitant la saturation des noeuds de stockage en cas d'image très lumineuse, tout en garantissant suffisamment de sensibilité pour une image peu lumineuse.

Dans le cas d'un obturateur global (« global shutter » en anglais), par contre, tous les pixels intègrent la lumière incidente simultanément, la lecture des pixels se faisant ultérieurement et ligne par ligne. Un fonctionnement en mode d'obturateur roulant est plus simple à réaliser et permet de maximiser la durée d'intégration pour un taux d'acquisition d'images donné, et donc la sensibilité du capteur, mais produit des artefacts dommageables (distorsion de la scène...) si la scène change rapidement (objet en mouvement, modification subite des conditions d'éclairage, ...). Ainsi, certaines applications nécessitent un obturateur global.

Il est également connu que les capteurs d'image à pixels actifs sont affectés par différents types de bruit.

Le document US2007/045681 propose une solution pour réduire le bruit lié au courant d'obscurité en effectuant des transferts de charges de la photodiode de manière pulsée dans le but de limiter cette contribution de bruit. Ce bruit est associé au courant de fuite de la jonction de la photodiode et trouve ses origines dans les phénonèmes de génération/recombinaison d'électrons.

Parmi ces différents types de bruit on peut également citer le bruit dit « kTC », ou bruit de réinitialisation. Avant d'acquérir une image, un pixel actif est réinitialisé à une tension (différence de potentiel par rapport à une masse) supposée connue ; puis il commence à accumuler des charges photogénérées, ce qui conduit à une diminution de sa tension. Si la tension de réinitialisation était parfaitement connue, la mesure de la tension à la sortie du pixel à la fin de l'intégration permettrait de déterminer l'intensité lumineuse incidente. En fait, la tension de réinitialisation varie de manière imprévisible d'une image à l'autre à cause des fluctuations thermiques des porteurs de charge. Pour supprimer cette source de bruit il est nécessaire d'échantillonner deux fois la tension de sortie du pixel - juste après la réinitialisation et à la fin de la période d'intégration pour un pixel à trois transistors (3T), ou juste après la réinitialisation et juste apres un transfert de charge pour un pixel à quatre transistors (4T) ou plus- et de soustraire le premier échantillon du deuxième. Cette technique est connue sous le nom de double échantillonnage corrélé (CDS, de l'anglais « Correlated Double Sampling »). Dans sa forme la plus simple, le double échantillonnage corrélé n'est pas compatible avec l'utilisation d'un obturateur global pour des capteurs matriciels disposant d'un nombre de ligne conséquent (de l'ordre de dix ou plus). Dans ce cas, il est connu d'avoir recours à une technique dite « quadruple échantillonnage corrélé » (CQS), qui consiste à acquérir deux images pour chaque image, l'une en l'absence de lumière (« image noire » représentative des tensions de réinitialisation de l'ensemble des pixels) et l'autre après avoir éclairé le pixel pendant le temps d'intégration voulu (« image d'intégration » obtenue apres un transfert globale des charges dans la matrice). L'acquisition des images noire et d'intégration est rendue possible par le fait que, dans les pixels compatibles avec cette technique, un transistor dit de transfert permet d'isoler la source des charges photogénérées (photodiode pincée) d'un noeud de stockage non éclairé. Aussi bien l'image noire que l'image d'intégration sont obtenues par différence entre deux échantillons de tension. L'image noire est la résultante de la différence entre une tension de référence et une tension acquise après la fin de la réinitialisation du noeud de stockage. L'image d'intégration est la résultante de la différence d'une tension acquise à la fin du temps d'intégration, après une opération de transfert effectuée de manière globale entre l'image noire et l'image d'intégration, et de la même tension de référence. Plus précisément, on procède d'abord, ligne par ligne, à la réinitialisation des noeuds de stockage et à l'acquisition concomitante de la tension de réinitialisation qui est un niveau de tension constant et peu bruité qui sert de tension de référence ; après un temps prédéfini on procède à l'arrêt de la réinitialisation du noeud de stockage et à une nouvelle acquisition de la tension des pixels représentatif du bruit échantillonné sur le noeud de stockage, la différence entre les deux acquisitions constituant l'image noire. Pendant ce temps, les photodiodes de tous les pixels intègrent des charges électriques qui, après l'acquisition de l'image noire, sont transférées globalement aux noeuds de stockage correspondants. Pour obtenir l'image d'intégration on procède à une première acquisition de la tension aux bornes des noeuds de stockage puis pendant la réinitialisation desdits noeuds, à une deuxième acquisition de tension, pour obtenir encore le niveau de référence, peu bruité, et enfin à la soustraction des deux tensions ainsi acquises.

L'image noire obtenue de cette façon constitue essentiellement une mesure du bruit post-réinitialisation (différence aléatoire entre la tension de réinitialisation et la tension aux bornes du noeud de stockage après réinitialisation), bruit qui affecte lui-même l'image d'intégration, car le noeud de stockage n'est pas réinitialisé entre les deux acquisitions. Par conséquent ce bruit peut être supprimé par soustraction des deux images. L'article de B. Fowler et al. « A 5.5 Mpixel 100 Frames/sec Wide Dynamic Range Low Noise CMOS Image Sensor for Scientific Applications », SPIE Proceedings 7536 - Sensors, Caméras, and Systems for Industrial/Scientific Applications XI, décrit un capteur d'images à pixels actifs mettant en oeuvre la technique CQS combinée à un obturateur électronique global. Un inconvénient d'un tel capteur est que la lecture des tensions des pixels est nécessairement destructive, car elle s'accompagne d'une réinitialisation des noeuds de stockage afin d'acquérir la tension de référence. Or, une lecture non destructive serait préférable dans certaines applications, car elle permettrait d'effectuer une pluralité de lectures des pixels tout en continuant à intégrer les charges photogénérées afin d'arrêter l'intégration quand le niveau d'exposition est optimal. On éviterait ainsi tout risque de sous- ou surexposition

L'invention vise à procurer un capteur d'images à pixels actifs permettant de combiner fonctionnement en mode d'obturateur global avec soustraction du bruit réinitialisation (ou kTC) et lecture non destructive des pixels. Accessoirement, l'invention vise également à minimiser le niveau de bruit global et la complexité de l'électronique de lecture des pixels.

Une idée à la base de l'invention, permettant d'atteindre ce but consiste à utiliser une référence de tension externe, générée par exemple au niveau du circuit de lecture de la matrice de pixels, au lieu d'utiliser comme niveau de référence la tension de réinitialisation des noeuds de stockage. Cela permet d'effectuer cette réinitialisation une seule fois, pendant la phase de lecture de l'image noire qui est ainsi non destructive. Par ailleurs, la tension de référence générée dans le circuit de lecture peut être beaucoup moins bruitée que la tension de réinitialisation des noeuds de stockage ; en effet, un circuit de génération d'un niveau de tension à hautes performances peut être prévu à l'extérieur de la matrice, mais ne peut raisonnablement pas être intégré aux pixels. En outre, cette tension de référence est disponible en permanence, ce qui simplifie la conception du circuit de lecture par rapport au cas décrit dans l'article précité de B. Fowler et al.

Un objet de l'invention est donc un capteur d'images à pixels actifs comportant une matrice de pixels organisés par lignes et colonnes ainsi qu'un circuit de lecture comportant une voie de lecture distincte pour chaque colonne de pixels, dans lequel chaque pixel comprend :
∘ une photodiode,
∘ un noeud de stockage des charges électriques intégrées par ladite photodiode,
∘ un transistor de transfert pour autoriser sélectivement le transfert desdites charges électrique de la photodiode au noeud de stockage,
∘ un transistor de réinitialisation du noeud de stockage pour relier sélectivement ledit noeud de stockage à une source de tension de réinitialisation,
∘ un transistor de sélection de ligne pour connecter sélectivement ledit pixel à la voie de lecture de la colonne à laquelle il appartient, et
∘ un transistor monté en suiveur de tension pour transférer à ladite voie de lecture la tension aux bornes du noeud de stockage par l'intermédiaire dudit transistor de sélection de ligne ;
caractérisé en ce que chaque voie de lecture comprend un bloc de soustraction ayant deux entrées et une sortie, ledit bloc de soustraction étant connecté pour recevoir sur une première entrée la tension aux bornes du noeud de stockage de l'un des pixels de la colonne correspondante par l'intermédiaire du transistor monté en suiveur de tension et du transistor de sélection de ligne dudit pixel et sur une seconde entrée une tension de référence de valeur sensiblement égale à la tension de réinitialisation des pixels de la matrice vue à l'entrée de la voie de lecture, et pour fournir à sa sortie un signal représentatif d'une différence des niveaux de tension présents à ses entrées ;
et en ce que ledit capteur comprend également un contrôleur configuré pour piloter les transistors des pixels et le circuit de lecture pour :
- effectuer une réinitialisation globale des photodiodes ;
- effectuer une réinitialisation des noeuds de stockage des pixels de la matrice et acquérir une première image numérique, dite image noire ; puis
- réaliser un transfert global de charge des photodiodes vers les noeuds de stockage desdits pixels ; puis
- acquérir une deuxième image numérique dite image d'intégration ;
de manière à réaliser une acquisition d'image en mode d'obturateur global avec soustraction du bruit de réinitialisation et lecture des pixels non destructrice des charges intégrées.

Selon différents modes de réalisation d'un tel capteur :
- Le capteur peut comprendre également au moins un générateur de ladite tension de référence, extérieur à ladite matrice de pixels.
- Chaque dit bloc soustracteur peut être une chaîne de numérisation différentielle configurée pour fournir à sa sortie un signal numérique représentatif de la différence des niveaux de tension analogiques présents à ses entrées.
- Ledit contrôleur peut être configuré pour piloter les transistors des pixels et le circuit de lecture pour réinitialiser les noeuds de stockage des pixels ligne par ligne.
- Un premier et un second échantillonneur - bloqueur peuvent être présents aux premières et secondes entrées de chaque dit bloc de soustraction, respectivement, et ledit contrôleur peut être configuré pour :
   a) activer le ou les transistors de réinitialisation de tous les pixels pour réinitialiser leurs photodiodes et leur noeuds de stockage ;
   b) activer les premiers échantillonneurs - bloqueurs de chaque voie de lecture, de telle sorte qu'un échantillon de la tension de référence soit présent sur la première entrée de chaque bloc de soustraction ;
   c) pour chaque colonne de pixel, et après réinitialisation des noeuds de stockage correspondants :
      c1) activer successivement les transistors de sélection de ligne,
      c2) en correspondance de chaque activation d'un transistor de sélection de ligne, activer le second échantillonneur - bloqueur de la voie de lecture correspondant à ladite colonne de telle sorte qu'un échantillon de tension soit présent sur la seconde entrée du bloc de soustraction correspondant ; puis
      c3) piloter le convertisseur analogique - numérique de ladite voie de lecture, moyennant quoi une première image numérique dite image noire est acquise ligne par ligne ;
   et ensuite :
   d) activer les transistors de transfert de tous les pixels, de façon à réaliser un transfert de charge global des photodiodes vers les noeuds de stockage desdits pixels ;
   e) activer les premiers échantillonneurs - bloqueurs de chaque voie de lecture, de telle sorte qu'un échantillon de la tension de référence soit présent sur la première entrée de chaque bloc soustracteur ;
   f) pour chaque colonne de pixel, et après transfert de charge vers les noeuds de stockage correspondants :
      f1) activer successivement les transistors de sélection de ligne,
      f2) en correspondance de chaque activation d'un transistor de sélection de ligne, activer le second échantillonneur - bloqueur de la voie de lecture correspondant à ladite colonne, puis
      f3) piloter le convertisseur analogique - numérique de ladite voie de lecture, moyennant quoi une deuxième image numérique dite image d'intégration (IIM) est acquise ligne par ligne ;
   aucune réinitialisation des photodiodes ou des noeuds de stockage n'étant effectuée entre les opérations b) et f3).
- Ledit contrôleur peut également être configuré pour répéter les opérations d) à f3) une ou plusieurs fois, en fonction d'un niveau de signal de ladite ou desdites images d'intégration, avant d'effectuer à nouveau les opérations a) à c), de telle sorte qu'une ou plusieurs images d'intégration soient acquises pour une même image noire.
- Le capteur peut également comporter un processeur numérique d'images configuré pour soustraire de ladite ou d'une dite image d'intégration l'image noire correspondante.
- Lesdits pixels peuvent comprendre un transistor de réinitialisation de la photodiode et un transistor de réinitialisation du noeud de stockage distincts.
- Chaque pixel peut également comprendre un transistor de réinitialisation de la photodiode pour relier sélectivement la photodiode à une source de tension de réinitialisation.

Un autre objet de l'invention est un procédé d'acquisition d'images au moyen d'un capteur d'images à pixels actifs comportant une matrice de pixels organisés par lignes et colonnes ainsi qu'un circuit de lecture comportant une voie de lecture distincte pour chaque colonne de pixels, dans lequel chaque pixel comprend :
∘ une photodiode,
∘ un noeud de stockage des charges électriques générées par ladite photodiode lorsqu'elle est éclairée,
∘ un transistor de transfert pour autoriser sélectivement le transfert desdites charges électrique de la photodiode au noeud de stockage,
∘ au moins un transistor de réinitialisation pour relier sélectivement la photodiode et le noeud de stockage à une source de tension de réinitialisation,
∘ un transistor de sélection de ligne pour connecter sélectivement ledit pixel à la voie de lecture de la colonne à laquelle il appartient, et
∘ un transistor monté en suiveur de tension pour transférer à ladite voie de lecture la tension aux bornes du noeud de stockage par l'intermédiaire dudit transistor de sélection de ligne ;
   le procédé comportant les étapes suivantes ;
   A) activer le ou les transistors de réinitialisation de tous les pixels pour réinitialiser leurs photodiodes et leur noeuds de stockage ;
   B) échantillonner une tension de référence, générée à l'intérieur dudit circuit de lecture et de valeur sensiblement égale à la tension de réinitialisation des pixels de la matrice ;
   C) pour chaque colonne de pixel, et après réinitialisation des noeuds de stockage correspondants : activer successivement les transistors de sélection de ligne, échantillonner la tension aux bornes du noeud de stockage du pixel correspondant, soustraire la tension de référence échantillonnée lors de l'étape B) de la tension ainsi échantillonnée et numériser le résultat, de manière à acquérir ligne par ligne une première image numérique dite image noire ;
   et ensuite :
   D) activer les transistors de transfert de tous les pixels, de façon à réaliser un transfert global de charge des photodiodes vers les noeuds de stockage desdits pixels ;
   E) échantillonner une tension de référence, générée à l'intérieur dudit circuit de lecture et de valeur sensiblement égale à la tension de réinitialisation des pixels de la matrice ;
   F) pour chaque colonne de pixel, et après transfert de charge vers les noeuds de stockage correspondants : activer successivement les transistors de sélection de ligne, échantillonner la tension aux bornes du noeud de stockage du pixel correspondant, soustraire la tension de référence échantillonnée lors de l'étape E) de la tension ainsi échantillonnée et numériser le résultat, de manière à acquérir ligne par ligne une deuxième image numérique dite image d'intégration.

Selon différents modes de réalisation d'un tel procédé :
- Les étapes D) à F) peuvent être répétées une ou plusieurs fois, en fonction d'un niveau de signal de ladite ou desdites images d'intégration, avant d'effectuer à nouveau lesdites étapes A) à C), de telle sorte qu'une ou plusieurs images d'intégration soient acquises pour une même image noire.
- Le procédé peut également comporter une étape consistant à soustraire de ladite ou d'une dite image d'intégration l'image noire correspondante.

D'autres caractéristiques, détails et avantages de l'invention ressortiront à la lecture de la description faite en référence aux dessins annexés donnés à titre d'exemple et qui représentent, respectivement :
- la figure 1, un diagramme fonctionnel d'ensemble d'un capteur d'images selon un mode de réalisation de l'invention ;
- la figure 2, le schéma électrique d'un pixel actif à cinq transistors pouvant être utilisé dans le capteur d'images de la figure 1 ;
- la figure 3, le schéma électrique simplifié d'une voie de lecture du capteur d'images de la figure 1 ;
- la figure 4 un chronogramme illustrant un premier mode de fonctionnement du capteur d'images de la figure 1 ; et
- la figure 5 un chronogramme illustrant un deuxième mode de fonctionnement du capteur d'images de la figure 1.

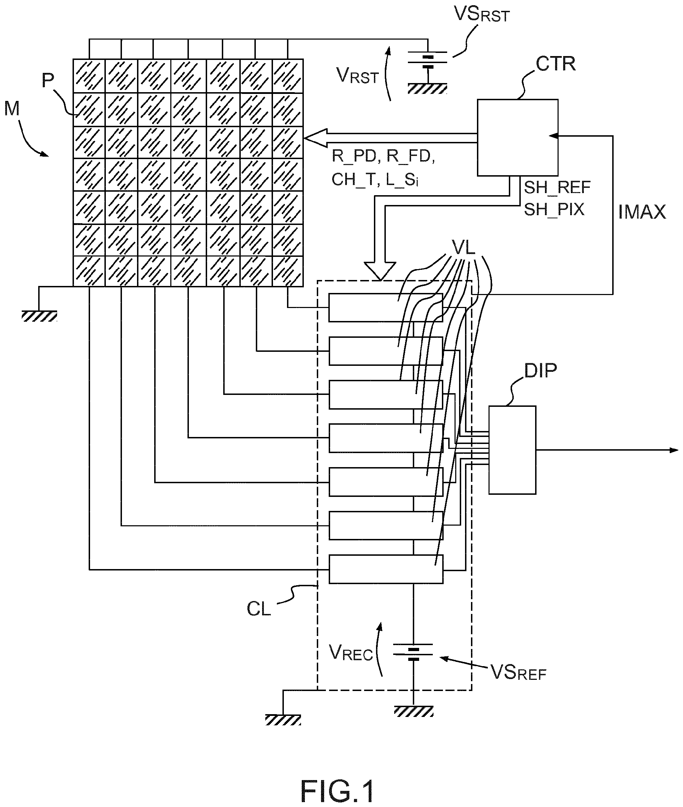

Comme illustré sur la figure 1, un capteur d'images selon un mode de réalisation de l'invention comprend une matrice M de pixels actifs P qui sont agencés par lignes et par colonnes. La matrice M utilisée pour l'acquisition d'images peut être un sous-ensemble d'une matrice plus grande, dont certaines lignes et/ou colonnes peuvent ne pas être utilisées dans une application donnée.

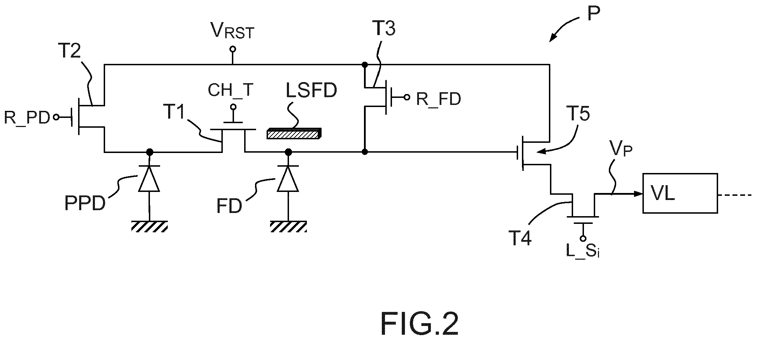

Un mode de réalisation des pixels de la matrice M est illustré sur la figure 2.

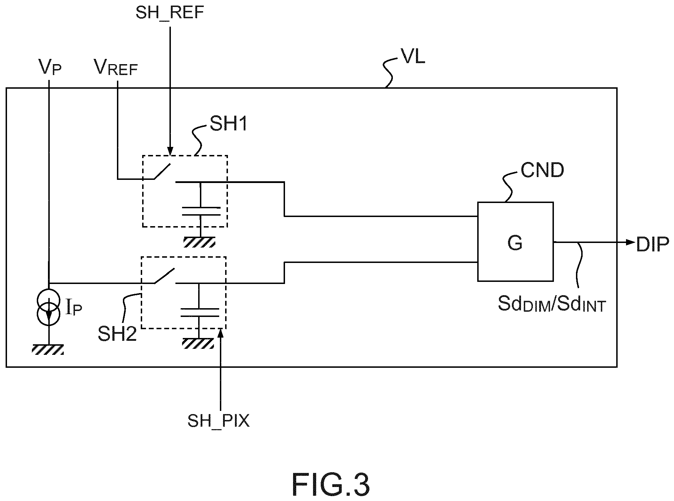

De manière conventionnelle, tous les pixels d'une même colonne sont reliés, par l'intermédiaire de transistors de sélection (non représentés sur la figure 1 ; référence T4 sur la figure 2) à une voie de lecture VL respective, dont un schéma simplifié est fourni par la figure 3. Lors de l'acquisition d'une image, les transistors de sélection de tous les pixels d'une même ligne sont activés en même temps ; ainsi une image est acquise ligne par ligne. La matrice M est connectée à une source VS_{RST} de tension continue V_{RST}. Cette tension est appelée « tension de réinitialisation » car, comme cela sera expliquée en référence à la figure 2, les noeuds de stockage sont réinitialisés en les connectant à la source VS_{RST} pour les amener au potentiel V_{RST}.

Les voies de lecture VL sont connectées à une source VS_{REF} de tension continue V_{REF}. Cette tension V_{REF}, appelée tension de référence, est sensiblement identique à l'image V_{RST COL} de la tension de réinitialisation V_{RST} sur le connecteur colonne CCi liant les pixels de la matrice au voies de lecture VL. Par « sensiblement identique » on entend que la tension V_{REF} est inclue dans la distribution possible des images sur le connecteur colonne des tensions de réinitialisation de l'ensemble des pixels de la matrice

Dans le mode de réalisation de la figure 1, les voies de lecture et la source de tension de référence sont rassemblées dans un circuit de lecture CL. Ce circuit reçoit en entrée les signaux analogiques issus de la matrice M et fournit à sa sortie des images numériques « brutes », qui sont traitées pas un processeur numérique d'images DIP. Ce dernier, notamment, soustrait les images noires des images d'intégration correspondantes afin de supprimer le bruit de réinitialisation.

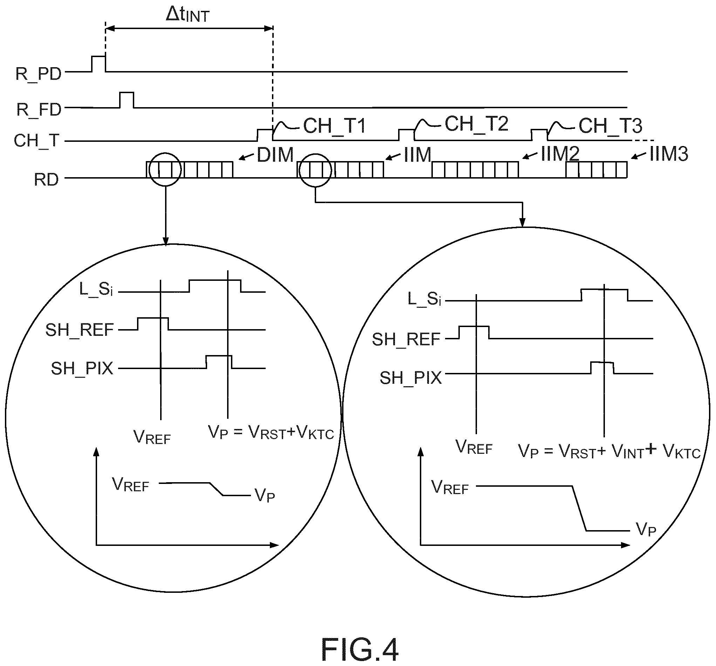

Le capteur de la figure 1 comprend également un contrôleur CTR qui génère des signaux de pilotage des transistors des pixels de la matrice (R_PD, R_FD, CH_T, L_Si) et des voies de lecture (SH_REF, SH_PIX). Des chronogrammes de ces signaux sont représentés sur la figure 4 et seront discutés en détail plus loin. Optionnellement, le contrôleur CTR peut aussi recevoir un signal IMAX provenant du circuit de lecture ou du processeur d'images et représentatif d'un niveau de signal des images d'intégrations acquises. Par exemple, IMAX peut correspondre au niveau de signal le plus élevé parmi les pixels de la matrice. L'utilisation de ce signal sera détaillée plus loin, en référence à la figure 4.

Le processeur numérique d'images DIP et le contrôleur CTR peuvent être constitués par (ou comprendre) un ou plusieurs microprocesseurs programmés de manière opportune et/ou des circuits numériques dédiés.

La figure 2 illustre l'architecture d'un pixel P de la matrice M. Il s'agit d'une architecture conventionnelle, dite « 5T », c'est-à-dire à 5 transistors. Ce pixel comprend une photodiode pincée PPD, qui intègre des charges électriques lorsque le pixel est éclairé. Un transistor T1 est connecté entre la photodiode et une jonction pn dite « flottante » (« floating diffusion » en anglais), identifiée par la référence FD, qui est protégée de la lumière par un écran LSFD. Lorsque le transistor T1 est inactif, la photodiode PPD accumule les charges d'origine photonique ; lorsque le transistor - piloté par le signal CH_T généré par le contrôleur CTR - est actif, les charges stockées dans la photodiode PPD sont transférées vers la jonction FD, qui sert alors de noeud de stockage de charge. Deux transistors T2, T3, pilotés par les signaux R_PD et R_FD, respectivement, permettent de réinitialiser la photodiode et le noeud de stockage de charge au travers de la source de tension VS_{RST}. La tension aux bornes du noeud de stockage de charge est lue par un transistor T5 connecté en suiveur de tension (le drain de ce transistor étant à la tension V_{RST}), et transmise à la voie de lecture de la colonne « i » à laquelle appartient le pixel par l'intermédiaire d'un transistor T4 de sélection de ligne, piloté par le signal L_Si (où « i » identifie la colonne).

La figure 3 illustre le schéma électrique simplifié d'une voie de lecture VL selon un mode de réalisation de l'invention. Cette voie de lecture comprend une source de courant I_{P} distribuant un courant de polarisation à l'ensemble des pixels d'une même colonne, en fonction de la sélection de la ligne L_Si. Cette voie de lecture comprend également un premier échantillonneur - bloqueur SH1 piloté par le signal SH_REF généré par le contrôleur CTR et dont l'entrée est reliée à la source de tension de référence VS_{REF}, ainsi qu'un second échantillonneur - bloqueur SH2 piloté par le signal SH_PIX généré par le contrôleur CTR et dont l'entrée est reliée aux pixels d'une même colonne de la matrice M via les transistors de sélection de ligne de ces pixels ; on indique par V_{P} la tension appliquée à l'entrée de SH2 lorsque l'un des ces transistors de sélection est activé. Les sorties de ces échantillonneurs - bloqueurs sont connectées aux entrées d'une chaine de numérisation différentielle CND, qui peut typiquement réaliser une conversion analogique - numérique à simple rampe. Le signal numérique généré par ce convertisseur, proportionnel à la différence numérisée entre les valeurs échantillonnés de V_{P} et V_{REF}, est fourni en entrée au processeur numérique d'images DIP.

La figure 4 illustre un mode de fonctionnement du capteur de la figure 1, et plus précisément un mode de réalisation sa séquence d'acquisition d'images.

La séquence commence par une réinitialisation globale (c'est-à-dire concernant tous les pixels) des photodiodes (signal R_PD). La réinitialisation globale des noeuds de stockage de charge (signal R_FD) a lieu peu avant la lecture de l'image DIM. Le front descendant du signal R_PD, c'est-à-dire la fin de l'opération de réinitialisation globale des photodiodes, déclenche le début du temps d'intégration de la lumière, qui a une durée Δt et se termine sur le front descendant du signal CH_T qui déclenche l'arrêt du transfert global de charge des photodiodes vers les noeuds de stockage de charge.

En parallèle du temps d'intégration Δt, on procède à l'acquisition de l'image noire DIM, qui est effectuée ligne par ligne. L'insert dans la partie inférieure gauche de la figure illustre les opérations qui conduisent à l'acquisition d'un pixel de l'image noire ; ces opérations sont effectuées simultanément pour toutes les colonnes (et donc toutes les voies de lecture) et successivement pour toutes les lignes. D'abord, le signal SH_REF active l'échantillonneur - bloqueur SH1 pour qu'il acquière un échantillon de la tension de référence V_{REF}. Ensuite, le signal L_Si active le transistor de sélection de ligne d'un pixel de la i-ème ligne de la matrice M; pendant le temps d'activation de ce transistor, le signal SH_PIX active l'échantillonneur - bloqueur SH2 pour qu'il acquière un échantillon de la tension V_{P} aux bornes du noeud de stockage de charge de ce pixel. Les trois opérations L_Si, SH_PIX et SH_REF pourraient également se faire simultanément pour toutes les lignes. Comme il n'y a pas eu de transfert de charge depuis l'opération de réinitialisation des noeuds de stockage (R_FD), la tension V_{P} est égale à V_{RST_COL}, l'image de la tension de réinitialisation V_{RST} sur le conducteur V_{P}, à laquelle s'ajoute - algébriquement - un bruit thermique V_{KTC} : V_{P}=V_{RST_COL}+V_{KTC}. Le signal de sortie de la chaine de numérisation différentielle CND est une image numérique de la différence des deux valeurs échantillonnées: sd_{DIM}=G(V_{RST_COL} +V_{KTC}-V_{REF}), où G représente un gain de la chaine de lecture VL. Etant donné que V_{REF}≅V_{RST_COL} et n'a presque pas de bruit, on peut écrire sd_{DIM}≅G·V_{KTC}, où l'indice « DIM » rappelle qu'il s'agit du signal relatif à l'image noire. On voit donc que l'image noire constitue essentiellement un mappage du bruit de réinitialisation de la matrice M.

L'acquisition de l'image d'intégration IIM (illustrée par l'insert dans la partie inférieure droite de la figure) comporte les mêmes opérations, mais qui sont mises en oeuvre après le transfert global de charge. Ainsi, dans ce cas V_{P} = V_{RST_COL}+V_{KTC}+V_{INT} où V_{INT} (généralement inférieur à 0) est le signal utile sur le conducteur V_{P}, proportionnel à l'énergie lumineuse interceptée par la photodiode du pixel pendant le temps d'intégration Δt. En se rappelant que V_{REF}≅V_{RST_COL} on peut donc écrire sd_{INT}≅G·(V_{INT} + V_{KTC}). Dès lors, le bruit de réinitialisation V_{KTC} peut être supprimé en calculant la différence entre sd_{INT} et sd_{DIM} : sd_{INT} - sd_{DIM} = G·V_{INT}). Avantageusement, cette soustraction est calculée numériquement par le processeur DIP.

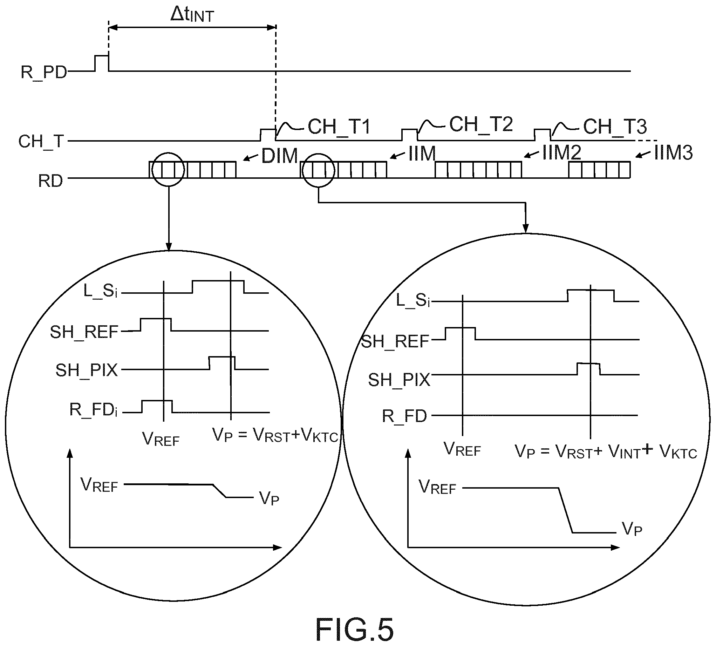

La figure 5 illustre un mode de fonctionnement alternatif du capteur de la figure 1, et plus précisément un autre mode de réalisation de sa séquence d'acquisition d'images, dans lequel les noeuds de stockage ne sont pas réinitialisés de manière simultanée, mais ligne par ligne pendant l'acquisition (effectuée également ligne par ligne) de l'image noire. Dans ce cas, le signal unique de réinitialisation des noeuds de stockage R_FD est remplacé par une pluralité de signaux de réinitialisation R_FDi, un par ligne. Pour chaque ligne « i », ce signal de réinitialisation R_FDi doit précéder l'échantillonnage du signal V_{P}, et donc le front descendant du signal SH_PIX. Par contre, la réinitialisation de toutes les photodiodes demeure globale, ainsi que leur transfert de charge, de telle sorte que la phase d'intégration est simultanée pour tous les pixels de la matrice. Le fait de réinitialiser les noeuds de stockage ligne par ligne réduit les fluctuations de la tension de réinitialisation, et donc le niveau de bruit statique de l'image.

Dans le capteur décrit par l'article précité de B. Fowler et al., la tension de référence est acquise en lisant chaque pixel pendant la réinitialisation de son noeud de stockage de charges. Ainsi, la tension de référence (ou de réinitialisation) n'est pas disponible en permanence, et doit être stockée dans une mémoire analogique afin d'être soustraite du signal utile. Pour mettre en oeuvre cette soustraction analogique, en outre, il est nécessaire de prévoir un module de commutation permettant d'inverser les deux entrées de l'amplificateur différentiel agencé à l'entrée de son convertisseur analogique - numérique pout changer le signe du signal de sortie ; l'invention permet d'éviter cette complexité additionnelle. En outre, le choix d'une référence hors de la matrice permet de réaliser une référence à très faible bruit, élément essentiel de la précédente opération. Ainsi, l'invention permet une simplification appréciable de l'architecture du circuit de lecture accompagnée d'une amélioration des performances en termes de bruit.

Mais le principal avantage de l'invention est que la lecture d'un pixel ne nécessite pas la réinitialisation de son noeud de stockage, ou de sa photodiode ; on dit qu'elle est non destructive. Ainsi, après le premier transfert global de charge (CH_T 1 sur la figure 4) et la lecture des pixels ligne par ligne, les photodiodes continuent à intégrer des charges photogénérées. Il est donc possible procéder à des transferts de charge ultérieurs - impulsions CH_T2, CH_T3... - suivies d'autres lectures non destructive. On obtient ainsi, pour une seule image noire, une pluralité d'images d'intégration IIM, IIM2, IIM3 correspondant à des temps d'intégration croissants (par exemple Δt_{INT}, 2·Δt_{INT} et 3·Δt_{INT}, respectivement.

Les temps d'intégrations ne sont pas nécessairement identiques si des impulsions R_PD devaient apparaitre entre CH_T1 et CH_T2 ou CH_T2 et CH_T3 par exemple). Cela permet en particulier d'optimiser l'exposition de l'image finale. Par exemple, après l'acquisition de la première image d'intégration, le processeur DIP peut déterminer l'intensité de signal IMAX correspondant au pixel le plus éclairé de cette image. Cette valeur est transmise au contrôleur CTR. Si IMAX est suffisamment proche d'une valeur prédéfinie, correspondant à la saturation du pixel, la séquence d'acquisition s'arrête ; autrement, on procède à une autre lecture non destructive, et ainsi de suite. Le temps d'intégration est ainsi adapté aux conditions d'éclairage, dans la limite des contraintes imposées par les exigences de cadence d'acquisition. Un tel mode de fonctionnement ne serait pas possible dans le cas du capteur de l'article précité de B. Fowler et al., dans lequel la lecture d'un pixel est nécessairement destructive, s'accompagnant toujours de sa réinitialisation. Pour atteindre le même niveau de signal cumulé avec le capteur de B. Fowler et al. il faudrait procéder à des acquisitions multiples, chacun avec sa propre réinitialisation génératrice de bruit. Dans le cas de l'invention, par contre, on ne soustrait que deux images dans tous les cas de figure, ce qui permet de réduire considérablement le niveau de bruit.

L'invention a été décrite en relation à un mode de réalisation particulier, mais de nombreuses variantes peuvent être envisagées. En particulier :
- Le capteur peut ne pas comprendre le processeur DIP, dont les fonctions peuvent être mises en oeuvre par un dispositif extérieur. Il en va de même pour le contrôleur CTR.
- Un seul et même processeur et/ou circuit numérique dédié peut être utilisé pour accomplir les fonctionnalités du processeur DIP et du contrôleur CTR. Ou alors, le processeur DIP et le contrôleur CTR peuvent être des dispositifs physiquement distincts.
- Le circuit de lecture, le processeur DIP, le contrôleur CTR, les sources de tension VS_{RST} et VS_{REF} peuvent être co-intégrés à la matrice M, ou pas. Ces éléments peuvent être réalisés en forme complètement intégrée ou utiliser des composants discrets.
- Plusieurs schémas connus peuvent être utilisés pour réaliser les sources de tension continue VS_{RST} et VS_{REF}.
- Les pixels actifs peuvent présenter des architectures différentes de celle (« 5T ») illustrée sur la figure 1. Par exemple, il est possible d'utiliser des pixels « 4T » qui ne comportent pas le transistor T2, de telle sorte que la réinitialisation de la photodiode se fait par l'intermédiaire de T1 et T3. En tout état de cause, chaque pixel doit comprendre au moins une photodiode, un noeud de stockage, un transistor de transfert, au moins un transistor de réinitialisation, un transistor de sélection de ligne et au-moins un transistor monté en amplificateur comme par exemple en suiveur de tension.
- Le schéma de la figure 3 est très simplifié. Des circuits de lecture connus de l'art antérieur peuvent être utilisés pour la mise en oeuvre de l'invention.
- Dans le schéma de la figure 3 on a considéré le cas où chaque voie de lecture comprend une chaîne de numérisation différentielle. En variante, les voies de lecture peuvent comprendre des circuits soustracteurs analogiques et fournir à leur sortie des signaux différentiels analogiques, numérisés à l'aide d'un convertisseur analogique - numérique ; ce dernier peut être commun à plusieurs voies de lecture, voire à l'intégralité d'entre elles, et ne doit pas nécessairement être intégré au circuit de lecture (il peut, par exemple, faire partie du processeur d'images). On pourrait même envisager une numérisation des signaux V_{P} et V_{REF} échantillonnés, suivie d'une opération de soustraction mise en oeuvre de manière numérique. En tout état de cause, chaque voie de lecture doit comprendre un bloc de soustraction - réalisé en forme analogique, numérique ou sous la forme d'un convertisseur analogique - numérique différentiel.
- La séquence d'acquisition d'image peut différer de celle qui a été décrite par rapport à la figure 4. Par exemple :
   - les photodiodes peuvent être réinitialisées avant, après ou en même temps que les noeuds de stockage ;
   - la tension de référence peut être acquise avant, après ou en même temps que la tension aux bornes de chaque noeud de stockage.
- Un capteur selon l'invention est adapté pour être utilisé en mode d'obturateur global tout en permettant une lecture non destructive des pixels. Néanmoins, il peut également être utilisé en mode d'obturateur roulant et l'acquisition d'images d'intégration multiples n'est qu'optionnelle.
- En cas d'acquisition d'images d'intégration multiples pour une même image noire, les temps d'intégration élémentaires séparant deux transferts de charge successifs peuvent ne pas être les mêmes.

## Revendications

1. Capteur d'images à pixels actifs comportant une matrice (M) de pixels (P) organisés par lignes et colonnes ainsi qu'un circuit de lecture (CL) comportant une voie de lecture (VL) distincte pour chaque colonne de pixels, dans lequel chaque pixel comprend :
∘ une photodiode (PPD),
∘ un noeud de stockage (FD) des charges électriques intégrées par ladite photodiode,
∘ un transistor de transfert (T1) pour autoriser sélectivement le transfert desdites charges électrique de la photodiode au noeud de stockage,
∘ un transistor de réinitialisation du noeud de stockage (T3) pour relier sélectivement ledit noeud de stockage à une source (VS_{RST}) de tension de réinitialisation (V_{RST}),
∘ un transistor de sélection de ligne (T4) pour connecter sélectivement ledit pixel à la voie de lecture de la colonne à laquelle il appartient, et
∘ un transistor (T5) monté en suiveur de tension pour transférer à ladite voie de lecture la tension aux bornes du noeud de stockage par l'intermédiaire dudit transistor de sélection de ligne ;
**caractérisé en ce que** chaque voie de lecture comprend un bloc de soustraction (CND) ayant deux entrées et une sortie, ledit bloc de soustraction étant connecté pour recevoir sur une première entrée la tension (V_{P}) aux bornes du noeud de stockage de l'un des pixels de la colonne correspondante par l'intermédiaire du transistor monté en suiveur de tension et du transistor de sélection de ligne dudit pixel et sur une seconde entrée une tension de référence (V_{REF}) externe à ladite matrice de valeur sensiblement égale à la tension de réinitialisation des pixels de la matrice vue à l'entrée de la voie de lecture, et pour fournir à sa sortie un signal représentatif d'une différence des niveaux de tension présents à ses entrées ;
et **en ce que** ledit capteur comprend également un contrôleur (CTR) configuré pour piloter les transistors des pixels et le circuit de lecture pour :
- effectuer une réinitialisation globale des photodiodes ;
- effectuer une réinitialisation des noeuds de stockage des pixels de la matrice et acquérir une première image numérique, dite image noire (DIM) ; puis
- réaliser un transfert global de charge des photodiodes vers les noeuds de stockage desdits pixels ; puis
- acquérir une deuxième image numérique dite image d'intégration (IIM) ;
de manière à réaliser une acquisition d'image en mode d'obturateur global avec soustraction du bruit de réinitialisation et lecture des pixels non destructrice des charges intégrées.

2. Capteur d'image selon la revendication 1 comprenant également au moins un générateur (VS_{REF}) de ladite tension de référence (V_{REF}), extérieur à ladite matrice de pixels.

3. Capteur d'image selon l'une des revendications précédentes, dans lequel chaque dit bloc soustracteur est une chaîne de numérisation différentielle configurée pour fournir à sa sortie un signal numérique représentatif de la différence des niveaux de tension analogiques présents à ses entrées.

4. Capteur d'image selon l'une des revendications précédentes dans lequel ledit contrôleur (CTR) est configuré pour piloter les transistors des pixels et le circuit de lecture pour réinitialiser les noeuds de stockage des pixels ligne par ligne.

5. Capteur d'image selon l'une des revendications précédentes dans lequel un premier et un second échantillonneur - bloqueur (SH1, SH2) sont présents aux premières et secondes entrées de chaque dit bloc de soustraction, respectivement, et ledit contrôleur est configuré pour :
a) activer le ou les transistors de réinitialisation de tous les pixels pour réinitialiser leurs photodiodes et leur noeuds de stockage ;
b) activer les premiers échantillonneurs - bloqueurs de chaque voie de lecture, de telle sorte qu'un échantillon de la tension de référence soit présent sur la première entrée de chaque bloc de soustraction (CND) ;
c) pour chaque colonne de pixel, et après réinitialisation des noeuds de stockage correspondants :
c1) activer successivement les transistors de sélection de ligne,
c2) en correspondance de chaque activation d'un transistor de sélection de ligne, activer le second échantillonneur - bloqueur de la voie de lecture correspondant à ladite colonne de telle sorte qu'un échantillon de tension soit présent sur la seconde entrée du bloc de soustraction correspondant ; puis
c3) piloter le convertisseur analogique - numérique de ladite voie de lecture, moyennant quoi une première image numérique dite image noire (DIM) est acquise ligne par ligne ;
et ensuite :
d) activer les transistors de transfert de tous les pixels, de façon à réaliser un transfert de charge global des photodiodes vers les noeuds de stockage desdits pixels ;
e) activer les premiers échantillonneurs - bloqueurs de chaque voie de lecture, de telle sorte qu'un échantillon de la tension de référence soit présent sur la première entrée de chaque bloc soustracteur ;
f) pour chaque colonne de pixel, et après transfert de charge vers les noeuds de stockage correspondants :
f1) activer successivement les transistors de sélection de ligne,
f2) en correspondance de chaque activation d'un transistor de sélection de ligne, activer le second échantillonneur - bloqueur de la voie de lecture correspondant à ladite colonne, puis
f3) piloter le convertisseur analogique - numérique de ladite voie de lecture, moyennant quoi une deuxième image numérique dite image d'intégration (IIM) est acquise ligne par ligne ;
aucune réinitialisation des photodiodes ou des noeuds de stockage n'étant effectuée entre les opérations b) et f3).

6. Capteur d'image selon la revendication 5 dans lequel ledit contrôleur est également configuré pour répéter les opérations d) à f3) une ou plusieurs fois, en fonction d'un niveau de signal (IMAX) de ladite ou desdites images d'intégration, avant d'effectuer à nouveau les opérations a) à c), de telle sorte qu'une ou plusieurs images d'intégration (IIM, IIM2, IIM3) soient acquises pour une même image noire.

7. Capteur d'image selon l'une des revendications 5 ou 6 comportant également un processeur numérique d'images (DIP) configuré pour soustraire de ladite ou d'une dite image d'intégration l'image noire correspondante.

8. Capteur d'image selon l'une des revendications précédentes dans lequel lesdits pixels comprennent un transistor de réinitialisation de la photodiode (T2) et un transistor de réinitialisation du noeud de stockage (T3) distincts.

9. Capteur d'image selon l'une des revendications précédentes, dans lequel chaque pixel comprend également un transistor de réinitialisation de la photodiode (T2) pour relier sélectivement la photodiode à une source (VS_{RST}) de tension de réinitialisation (V_{RST}).

10. Procédé d'acquisition d'images au moyen d'un capteur d'images à pixels actifs comportant une matrice (M) de pixels (P) organisés par lignes et colonnes ainsi qu'un circuit de lecture (CL) comportant une voie de lecture (VL) distincte pour chaque colonne de pixels, dans lequel chaque pixel comprend :
∘ une photodiode (PPD),
∘ un noeud de stockage (FD) des charges électriques générées par ladite photodiode lorsqu'elle est éclairée,
∘ un transistor de transfert (T1) pour autoriser sélectivement le transfert desdites charges électrique de la photodiode au noeud de stockage,
∘ au moins un transistor de réinitialisation (T2, T3) pour relier sélectivement la photodiode et le noeud de stockage à une source (VS_{RST}) de tension de réinitialisation (V_{RST}),
∘ un transistor de sélection de ligne (T4) pour connecter sélectivement ledit pixel à la voie de lecture de la colonne à laquelle il appartient, et
∘ un transistor (T5) monté en suiveur de tension pour transférer à ladite voie de lecture la tension aux bornes du noeud de stockage par l'intermédiaire dudit transistor de sélection de ligne ;
le procédé comportant les étapes suivantes ;
A) activer le ou les transistors de réinitialisation de tous les pixels pour réinitialiser leurs photodiodes et leur noeuds de stockage ;
B) échantillonner une tension de référence externe à ladite matrice, générée à l'intérieur dudit circuit de lecture et de valeur sensiblement égale à la tension de réinitialisation des pixels de la matrice ;
C) pour chaque colonne de pixel, et après réinitialisation des noeuds de stockage correspondants : activer successivement les transistors de sélection de ligne, échantillonner la tension aux bornes du noeud de stockage du pixel correspondant, soustraire la tension de référence échantillonnée lors de l'étape B) de la tension ainsi échantillonnée et numériser le résultat, de manière à acquérir ligne par ligne une première image numérique dite image noire ;
et ensuite :
D) activer les transistors de transfert de tous les pixels, de façon à réaliser un transfert global de charge des photodiodes vers les noeuds de stockage desdits pixels ;
E) échantillonner une tension de référence, générée à l'intérieur dudit circuit de lecture et de valeur sensiblement égale à la tension de réinitialisation des pixels de la matrice ;
F) pour chaque colonne de pixel, et après transfert de charge vers les noeuds de stockage correspondants : activer successivement les transistors de sélection de ligne, échantillonner la tension aux bornes du noeud de stockage du pixel correspondant, soustraire la tension de référence échantillonnée lors de l'étape E) de la tension ainsi échantillonnée et numériser le résultat, de manière à acquérir ligne par ligne une deuxième image numérique dite image d'intégration.

11. Procédé selon la revendication 10 dans lequel les étapes D) à F) sont répétées une ou plusieurs fois, en fonction d'un niveau de signal de ladite ou desdites images d'intégration, avant d'effectuer à nouveau lesdites étapes A) à C), de telle sorte qu'une ou plusieurs images d'intégration (IIM, IIM2, IIM3) soient acquises pour une même image noire.

12. Procédé selon l'une des revendications 10 ou 11 comportant également une étape consistant à soustraire de ladite ou d'une dite image d'intégration l'image noire correspondante.

## Patentansprüche

1. Bildsensor mit aktiven Pixeln, umfassend eine Matrix (M) von Pixeln (P), die nach Reihen und Spalten organisiert sind, sowie eine Leseschaltung (CL), die einen separaten Lesekanal (VL) für jede Pixelspalte umfasst, wobei jedes Pixel Folgendes umfasst:
∘ eine Fotodiode (PPD),
∘ einen Speicherknoten (FD) für durch die Fotodiode integrierte elektrische Ladungen,
∘ einen Übertragungstransistor (T1) zum selektiven Autorisieren der Übertragung der elektrischen Ladungen der Fotodiode zum Speicherknoten,
∘ einen Transistor (T3) zum Neuinitialisieren des Speicherknotens, um den Speicherknoten selektiv mit einer Quelle (VS_{RST}) von Neuinitialisierungsspannung (V_{RST}) zu verbinden,
∘ einen Reihenauswahltransistor (T4) zum selektiven Verbinden des Pixels mit dem Lesekanal der Spalte, zu der er gehört, und
∘ einen Transistor (T5), montiert als Spannungsfolger zum Übertragen der Spannung an den Anschlüssen des Speicherknotens zu dem Lesekanal mittels des Reihenauswahltransistors;
**dadurch gekennzeichnet, dass** jeder Lesekanal einen Subtrahierblock (CND) mit zwei Eingängen und einem Ausgang umfasst, wobei der Subtrahierblock zum Empfangen, an einem ersten Eingang, der Spannung (V_{P}) an den Anschlüssen des Speicherknotens des einen der Pixel der entsprechenden Spalte, mittels des als Spannungsfolger montierten Transistors und des Reihenauswahltransistors des Pixels, und, an einem zweiten Eingang, einer externen Referenzspannung (V_{REF}) außerhalb der Matrix mit einem Wert, der im Wesentlichen gleich der Neuinitialisierungsspannung der Pixel der Matrix ist, gesehen am Eingang des Lesekanals, und zum Anlegen eines Signals an seinem Ausgang geschaltet ist, das eine Differenz der an seinen Eingängen vorliegenden Spannungspegel repräsentiert;
und dadurch, dass der Sensor auch eine Steuerung (CTR) umfasst, konfiguriert zum Steuern der Transistoren der Pixel und der Leseschaltung zum:
- Bewirken einer globalen Neuinitialisierung der Fotodioden;
- Bewirken einer Neuinitialisierung der Speicherknoten der Pixel der Matrix und Erfassen eines ersten digitalen Bildes, Schwarzbild (DIM) genannt; dann
- Realisieren einer globalen Ladungsübertragung der Fotodioden zu den Speicherknoten der Pixel; dann
- Erfassen eines zweiten digitalen Bildes, Integrationsbild (IIM) genannt;
um eine Bilderfassung im Global-Shutter-Modus mit Subtraktion von Neuinitialisierungsrauschen und zerstörungsfreies Lesen der Pixel der integrierten Ladungen zu realisieren.

2. Bildsensor nach Anspruch 1, der auch wenigstens einen Generator (VS_{REF}) der Referenzspannung (V_{REF}) außerhalb der Pixelmatrix umfasst.

3. Bildsensor nach einem der vorherigen Ansprüche, bei dem jeder Subtrahierblock eine differentielle Digitialisierungskette ist, konfiguriert zum Anlegen, an seinem Ausgang, eines digitalen Signals, das die Differenz der an seinen Eingängen vorhandenen analogen Spannungspegel repräsentiert.

4. Bildsensor nach einem der vorherigen Ansprüche, bei dem die Steuerung (CTR) zum Steuern der Transistoren der Pixel und der Leseschaltung zum Neuinitialisieren der Speicherknoten der Pixel Reihe für Reihe konfiguriert ist.

5. Bildsensor nach einem der vorherigen Ansprüche, bei dem ein erster und ein zweiter Sampler-Blocker (SH1, SH2) jeweils am ersten und zweiten Eingang jedes Subtrahierblocks vorhanden sind, wobei die Steuerung konfiguriert ist zum:
a) Aktivieren der ein oder mehreren Neuinitialisierungstransistoren aller Pixel zum Neuinitialisieren ihrer Fotodioden und ihrer Speicherknoten;
b) Aktivieren der ersten Sampler-Blocker jedes Lesekanals, damit eine Abtastung der Referenzspannung am ersten Eingang jedes Subtrahierblocks (CND) vorhanden ist;
c) für jede Pixelspalte und nach dem Neuinitialisieren der entsprechenden Speicherknoten:
c1) aufeinander folgendes Aktivieren der Reihenauswahltransistoren,
c2) Aktivieren, entsprechend jeder Aktivierung eines Reihenauswahltransistors, des zweiten Sampler-Blockers des Lesekanals, der der Spalte entspricht, so dass eine Spannungsabtastung am zweiten Eingang des entsprechenden Subtrahierblocks vorliegt; dann
c3) Steuern des Analog-Digital-Wandlers des Lesekanals, mittels dessen ein erstes digitales Bild, Schwarzbild (DIM) genannt, Reihe für Reihe erfasst wird;
und dann:
d) Aktivieren der Übertragungstransistoren aller Pixel, um eine globale Ladungsübertragung der Fotodioden zu den Speicherknoten der Pixel zu realisieren;
e) Aktivieren der ersten Sampler-Blocker jedes Lesekanals, damit eine Abtastung der Referenzspannung am ersten Eingang jedes Subtrahierblocks vorliegt,
f) für jede Pixelspaltung und nach der Ladungsübertragung zu den entsprechenden Speicherknoten:
f1) aufeinander folgendes Aktivieren der Reihenauswahltransistoren,
f2) Aktivieren, entsprechend jeder Aktivierung eines Reihenauswahltransistors, des zweiten Sampler-Blockers des der Spalte entsprechenden Lesekanals, dann
f3) Steuern des Analog-Digital-Wandlers des Lesekanals, mittels dessen ein zweites digitales Bild, Integrationsbild (IIM) genannt, Reihe für Reihe erfasst wird;
wobei keine Neuinitialisierung der Fotodioden oder Speicherknoten zwischen den Operationen b) und f3) bewirkt wird.

6. Bildsensor nach Anspruch 5, bei dem die Steuerung auch zum Wiederholen der Operationen d) bis f3) ein oder mehrere Male in Abhängigkeit von einem Signalpegel (IMAX) der ein oder mehreren Integrationsbilder vor dem erneuten Durchführen der Operationen a) bis c) konfiguriert ist, so dass ein oder mehrere Integrationsbilder (IIM, IIM2, IIM3) für ein selbes Schwarzbild erfasst wird/werden.

7. Bildsensor nach Anspruch 5 oder 6, der auch einen digitalen Bildprozessor (DIP) umfasst, konfiguriert zum Subtrahieren des entsprechenden Schwarzbilds von dem oder einem Integrationsbild.

8. Bildsensor nach einem der vorherigen Ansprüche, bei dem die Pixel einen Transistor zum Neuinitialisieren der Fotodiode (T2) und einen Transistor zum Neuinitialisieren des Speicherknotens (T3) umfassen, die sich voneinander unterscheiden.

9. Bildsensor nach einem der vorherigen Ansprüche, bei dem jedes Pixel auch einen Transistor zum Neuinitialisieren der Fotodiode (T2) zum selektiven Verbinden der Fotodiode mit einer Quelle (VS_{RST}) von Neuinitialisierungsspannung (V_{RST}) umfasst.

10. Verfahren zum Erfassen von Bildern mittels eines Bildsensors mit aktiven Pixeln, umfassend eine Matrix (M) von Pixeln (P), die nach Reihen und Spalten organisiert sind, sowie eine Leseschaltung (CL), die einen für jede Pixelspalte unterschiedlichen Lesekanal (VL) umfasst, wobei jedes Pixel Folgendes umfasst:
∘ eine Fotodiode (PPD),
∘ einen Speicherknoten (FD) für die von der Fotodiode bei deren Beleuchtung erzeugten elektrischen Ladungen,
∘ einen Übertragungstransistor (T1) zum selektiven Autorisieren der Übertragung der elektrischen Ladungen der Fotodiode zum Speicherknoten,
∘ wenigstens einen Neuinitialisierungstransistor (T2, T3) zum selektiven Verbinden der Fotodiode und des Speicherknotens mit einer Quelle (VS_{RST}) von Neuinitialisierungsspannung (V_{RST}),
∘ einen Reihenauswahltransistor (T4) zum selektiven Verbinden des Pixels mit dem Lesekanal der Spalte, zu der er gehört, und
∘ einen Transistor (T5), montiert als Spannungsfolger zum Übertragen der Spannung an den Anschlüssen des Speicherknotens zu dem Lesekanal mittels des Reihenauswahltransistors;
wobei das Verfahren die folgenden Schritte beinhaltet:
A) Aktivieren der ein oder mehreren Neuinitialisierungstransistoren aller Pixel zum Neuinitialisieren ihrer Fotodioden und ihrer Speicherknoten;
B) Abtasten einer Referenzspannung außerhalb der Matrix, erzeugt im Inneren der Leseschaltung und von im Wesentlichen gleichem Wert wie die der Neuinitialisierungsspannung der Pixel der Matrix;
C) für jede Pixelspalte und nach dem Neuinitialisieren der entsprechenden Speicherknoten: aufeinander folgendes Aktivieren der Reihenauswahltransistoren, Abtasten der Spannung an den Anschlüssen des Speicherknotens des entsprechenden Pixels, Subtrahieren der in Schritt B) abgetasteten Referenzspannung von der solcherart abgetasteten Spannung, und Digitalisieren des Ergebnisses, um Reihe für Reihe ein Schwarzbild genanntes digitales erstes Bild zu erfassen;
und dann:
D) Aktivieren der Übertragungstransistoren aller Pixel, um eine globale Ladungsübertragung der Fotodioden zu den Speicherknoten der Pixel zu realisieren;
E) Abtasten einer Referenzspannung, erzeugt im Inneren der Leseschaltung und von einem im Wesentlichen gleichen Wert wie die der Neuinitialisierungsspannung der Pixel der Matrix;
F) für jede Pixelspalte und nach der Ladungsübertragung zu den entsprechenden Speicherknoten: aufeinander folgendes Aktivieren der Reihenauswahltransistoren, Abtasten der Spannung an den Anschlüssen des Speicherknotens des entsprechenden Pixels, Subtrahieren der in Schritt E) abgetasteten Referenzspannung von der solcherart abgetasteten Spannung und Digitalisieren des Ergebnisses, um Reihe für Reihe ein Integrationsbild genanntes digitales zweites Bild zu erfassen.

11. Verfahren nach Anspruch 10, bei dem die Schritte D) bis F) ein oder mehrere Male in Abhängigkeit von einem Signalpegel der ein oder mehreren Integrationsbilder vor dem erneuten Bewirken der Schritte A) bis C) wiederholt werden, so dass ein oder mehrere Integrationsbilder (IIM, IIM2, IIM3) für ein und dasselbe Schwarzbild erfasst werden.

12. Verfahren nach Anspruch 10 oder 11, das auch einen Schritt umfasst, der im Subtrahieren des entsprechenden Schwarzbildes von dem oder einem Integrationsbild besteht.

## Claims

1. Active pixel image sensor comprising a matrix (M) of pixels (P) organised in rows and columns and a reading circuit (CL) comprising a separate reading channel (VL) for each column of pixels, in which each pixel comprises:
∘ a photodiode (PPD),
∘ a storage node (FD) for the electrical charges integrated by the photodiode,
∘ a transfer transistor (T1) in order to selectively authorise the transfer of the electrical charges from the photodiode to the storage node,
∘ a transistor (T3) for resetting the storage node in order to selectively connect the storage node to a source (VS_{RST}) of resetting voltage (V_{RST}),
∘ a row selection transistor (T4) for selectively connecting the pixel to the reading channel of the column to which it belongs, and
∘ a transistor (T5) which is mounted as a voltage follower in order to transfer the voltage at the terminals of the storage node to the reading channel via the row selection transistor;
**characterised in that** each reading channel comprises a subtraction block (CND) which has two inputs and an output, the subtraction block being connected to receive at a first input the voltage (Vp) at the terminals of the storage node of one of the pixels of the corresponding column via the transistor which is mounted as a voltage follower and the row selection transistor of the pixel and at a second input a reference voltage (V_{REF}) which is external to the matrix having a value which is substantially equal to the resetting voltage of the pixels of the matrix seen at the input of the reading channel, and to provide at the output thereof a signal which represents a voltage level difference present at the inputs thereof;
and **in that** the sensor also comprises a controller (CTR) configured to control the transistors of the pixels and the reading circuit in order to
- carry out a global resetting of the photodiodes;
- carry out a resetting of the storage nodes of the pixels of the matrix and acquire a first digital image, referred to as a black image (DIM); then
- carry out a global charge transfer of the photodiodes to the storage nodes of the pixels; then
- acquire a second digital image referred to as an integration image (IIM);
in order to carry out an image acquisition in global shutter mode with subtraction of the resetting noise and non-destructive reading of the pixels of the integrated charges.

2. Image sensor according to claim 1, also comprising at least one generator (VS_{REF}) of the reference voltage (V_{REF}) external to the pixel matrix.

3. Image sensor according to either of the preceding claims, wherein each subtraction block is a differential digitisation chain which is configured to provide at the output thereof a digital signal which represents the difference of the levels of analogue voltage present at the inputs thereof.

4. Image sensor according to any one of the preceding claims, wherein the controller (CTR) is configured to control the transistors of the pixels and the reading circuit in order to reset the storage nodes of the pixels row by row.

5. Image sensor according to any one of the preceding claims, wherein a first and a second sampler-blocker (SH1, SH2) are present at the first and second inputs of each subtraction block, respectively, and the controller is configured to:
a) activate the resetting transistor(s) of all the pixels in order to reset the photodiodes thereof and the storage nodes thereof;
b) activate the first samplers/blockers of each reading channel so that a sample of the reference voltage is present at the first input of each subtraction block (CND);
c) for each pixel column, and after resetting the corresponding storage nodes:
c1) successively activate the row selection transistors,
c2) in accordance with each activation of a row selection transistor, activate the second sampler/blocker of the reading channel corresponding to the column so that a voltage sample is present at the second input of the corresponding subtraction block; then
c3) control the analogue/digital converter of the reading channel, by means of which a first digital image referred to as the black image (DIM) is acquired row by row;
and then
d) activate the transfer transistors of all the pixels in order to carry out a global charge transfer of the photodiodes to the storage nodes of the pixels;
e) activating the first samplers/blockers of each reading channel so that a sample of the reference voltage is present at the first input of each subtraction block;
f) for each pixel column, and after transferring charge to the corresponding storage nodes:
f1) successively activate the row selection transistors,
f2) in accordance with each activation of a row selection transistor, activate the second sampler/blocker of the reading channel corresponding to the column, then
f3) control the analogue/digital converter of the reading channel, by means of which a second digital image referred to as an integration image (IIM) is acquired row by row;
no resetting of the photodiodes or the storage diodes being carried out between the operations b) and f3).

6. Image sensor according to claim 5, wherein the controller is also configured to repeat the operations d) to f3) once or several times, in accordance with a signal level (IMAX) of the integration image(s), before carrying out the operations a) to c) again so that one or more integration image(s) (IIM, IIM2, IIM3) is/are acquired for the same black image.

7. Image sensor according to either claim 5 or claim 6, also comprising a digital image processor (DIP) configured to subtract the corresponding black image from the or an integration image.

8. Image sensor according to any one of the preceding claims, wherein the pixels comprise a separate transistor (T2) for resetting the photodiode and a transistor (T3) for resetting the storage node.

9. Image sensor according to any one of the preceding claims, wherein each pixel also comprises a transistor (T2) for resetting the photodiode in order to selectively connect the photodiode to a source (VS_{RST}) of resetting voltage (V_{RST}).

10. Method for acquiring images using an active pixel image sensor comprising a matrix (M) of pixels (P) organised in rows and columns and a reading circuit (CL) comprising a separate reading channel (VL) for each pixel column, in which each pixel comprises:
∘ a photodiode (PPD),
∘ a storage node (FD) for the electrical changes generated by the photodiode when it is illuminated,
∘ a transfer transistor (T1) for selectively authorising the transfer of the electrical charges of the photodiode to the storage node,
∘ at least one resetting transistor (T2, T3) for selectively connecting the photodiode and the storage node to a source (VS_{RST}) of resetting voltage (V_{RST}),
∘ a row selection transistor (T4) for selectively connecting the pixel to the reading channel of the column to which it belongs, and
∘ a transistor (T5) which is mounted as a voltage follower in order to transfer the voltage at the terminals of the storage node to the reading channel via the row selection transistor;
the method comprising the following steps;
A) activating the resetting transistor(s) of all the pixels in order to reset the photodiodes and the storage nodes thereof;
B) sampling a reference voltage which is external to the matrix, which is generated inside the reading circuit and which has a value which is substantially equal to the resetting voltage of the matrix pixels;
C) for each pixel column, and after resetting the corresponding storage nodes: successively activating the row selection transistors, sampling the voltage at the terminals of the storage node of the corresponding pixel, subtracting the reference voltage sampled during step B) from the voltage thus sampled and digitising the result in order to acquire row by row a first digital image referred to as a black image;
and then:
D) activating the transfer transistors of all the pixels in order to carry out a global charge transfer of the photodiodes to the storage nodes of the pixels;
E) sampling a reference voltage which is generated inside the reading circuit and which has a value which is substantially equal to the resetting voltage of the pixels of the matrix;
F) for each pixel column, and after transferring charge to the corresponding storage nodes: successively activating the row selection transistors, sampling the voltage at the terminals of the storage node of the corresponding pixel, subtracting the reference voltage sampled during step E) from the voltage thus sampled and digitising the result in order to acquire row by row a second digital image referred to as an integration image.

11. Method according to claim 10, wherein the steps D) to F) are repeated once or several times in accordance with a signal level of the integration image(s), before carrying out the steps A) to C) again so that one or more integration image(s) (IIM, IIM2, IIM3) is/are acquired for the same black image.

12. Method according to either claim 10 or claim 11, also comprising a step involving subtracting the corresponding black image from the or an integration image.
